Europäisches Patentamt

European Patent Office

Office européen des brevets

(11) Numéro de publication: **0 362 083**

**A1**

## (12) DEMANDE DE BREVET EUROPEEN

(21) Numéro de dépôt: **89420345.4**

(22) Date de dépôt: **14.09.89**

(51) Int. Cl.⁵: **H01M 2/10 , H05K 7/18**

(30) Priorité: **29.09.88 FR 8812881**

(43) Date de publication de la demande:
**04.04.90 Bulletin 90/14**

(84) Etats contractants désignés:
**BE CH DE ES GB IT LI SE**

(71) Demandeur: **MERLIN GERIN**
**2, chemin des Sources**
**F-38240 Meylan(FR)**

(72) Inventeur: **Thouvenin, Jean-Marie**
**MERLIN GERIN Sce. Brevets**
**F-38050 Grenoble Cédex(FR)**
Inventeur: **Bouchard, Jean-Pierre**
**MERLIN GERIN Sce. Brevets**
**F-38050 Grenoble Cédex(FR)**
Inventeur: **Doize, Jacques**
**MERLIN GERIN Sce. Brevets**
**F-38050 Grenoble Cédex(FR)**

(74) Mandataire: **Kern, Paul et al**
**Merlin Gerin Sce. Brevets 20, rue Henri Tarze**
**F-38050 Grenoble Cédex(FR)**

(54) **Armoire modulaire pour batteries d'accumulateurs électriques.**

(57) Une armoire modulaire comprend une pluralité de modules batteries ayant chacun un châssis (30) extractible présentant une ossature métallique de forme parallélépipédique, comportant un socle (32) de section rectangulaire parallèle aux différentes étagères (68), des organes de roulement (34) fixés à la base du socle (32) pour assurer le déplacement du module (14) dans la direction de la profondeur entre une position d'insertion et une position d'extraction, un premier flasque avant (28) vertical s'étendant perpendiculairement au socle (32), un deuxième flasque arrière (58) parallèle au premier flasque (28) avec interposition des étagères (68) dans la direction de la profondeur, un fond latéral fermé de liaison des deux flasques (28,58) et du socle (32), et un espace (106) libre transversal ménagé entre les blocs accumulateurs (56) et la face latérale (90) ouverte à l'opposé du fond (60), le déplacement en translation du module (14) vers la position d'extraction autorisant l'accessibilité totale de l'ensemble des blocs accumulateurs à travers ladite face latérale (90) ouverte.

Fig. 7   14

## ARMOIRE MODULAIRE POUR BATTERIES D'ACCUMULATEURS ELECTRIQUES

L'invention est relative à une armoire modulaire pour batteries d'accumulateurs électriques, associée notamment à une cellule onduleur, et comprenant une pluralité de modules batteries ayant chacun un châssis extractible, équipé d'étagères horizontales superposées dans le sens de la hauteur pour le support des blocs accumulateurs.

La répartition des blocs accumulateurs sur les étagères des armoires connues pose généralement les problèmes suivants:

- la disposition horizontale des étagères est susceptible de perturber l'aération du volume intermédiaire de l'armoire, et il est alors indispensable de prévoir une grande surface de grilles de ventilation, notamment sur toute la hauteur, ce qui peut affecter l'esthétique de l'armoire;

- au moins la moitié du nombre de blocs accumulateurs est difficile d'accès lors des opérations de maintenance.

L'objet de l'invention consiste à améliorer et l'accessibilité des blocs accumulateurs à l'intérieur d'une armoire d'un module batteries et l'assemblage d'un module à une cellule onduleur ou à un autre module.

L'armoire selon l'invention est caractérisé en ce que le châssis comporte :

- des organes de roulements fixés à la base du socle pour assurer le déplacement du module dans la direction de la profondeur entre une position d'insertion et une position d'extraction,

- un premier flasque avant vertical s'étendant perpendiculairement au socle,

- un deuxième flasque arrière parallèle au premier flasque avec interposition des étagères dans la direction de la profondeur,

- un fond latéral fermé de liaison des deux flasques et du socle,

- un espace libre transversal ménagé entre les blocs accumulateurs et la face latérale ouverte à l'opposé du fond, le déplacement en translation du module vers la position d'extraction autorisant l'accessibilité totale de l'ensemble des blocs accumulateurs à travers ladite face latérale ouverte,

- des moyens de guidage latéraux pour permettre d'une part l'accrochage mécanique en position d'insertion, de deux modules ou d'un module à la cellule onduleur et d'autre part le guidage en translation lors du mouvement en translation du module.

Le positionnement des blocs accumulateurs sur les étagères peut être du type couché ou debout en fonction de l'encombrement et du type des accumulateurs.

La ventilation interne des modules s'opère à travers le volume vertical de l'espace libre grâce à la disposition judicieuse de grilles d'aspiration et d'échappement.

Le déplacement d'un module s'effectue au moyen de poignées de préhension rabattables fixées au flasque avant du châssis.

Chaque étagère est composée d'une plaquette support solidarisée aux deux flasques avant et arrière, et une cornière de maintien fixée au fond dans un même plan horizontal.

La réalisation du câblage entre les différentes rangées des modules est effectué de façon modulaire et standard.

D'autres avantages et caractéristiques ressortiront plus clairement de la description qui va suivre d'un exemple de réalisation, donné à titre d'exemple non limitatif, et représenté aux dessins annexés dans lesquels:

- la figure 1 montre une vue en élévation d'une cellule onduleur associée à une armoire modulaire d'une batterie d'accumulateurs;

- la figure 2 est une vue identique de la figure 1, après enlèvement de l'habillage externe des modules batteries de l'armoire;

- les figures 3 et 4 représentent des vues de détail, à échelles agrandies de la figure 2, concernant respectivement les dispositifs de guidage supérieur et inférieur de deux modules accolés;

- la figure 5 est une vue en plan de la figure 1 montrant la manipulation des modules lors d'une opération de maintenance, le toit des trois premiers modules étant enlevé;

- la figure 6 est une vue éclatée en perspective du châssis d'un module batterie;

- la figure 7 est une vue en perspective d'un module montrant le châssis assemblé prêt à recevoir les blocs accumulateurs et l'habillage externe;

- la figure 8 est une vue d'un module selon la ligne VIII - VIII de la figure 1, montrant la répartition interne des blocs accumulateurs par la face latérale ouverte du châssis;

- la figure 9 représente une vue de profil de la figure 8,

- la figure 10 est une vue de détail à échelle agrandie de la figure 9.

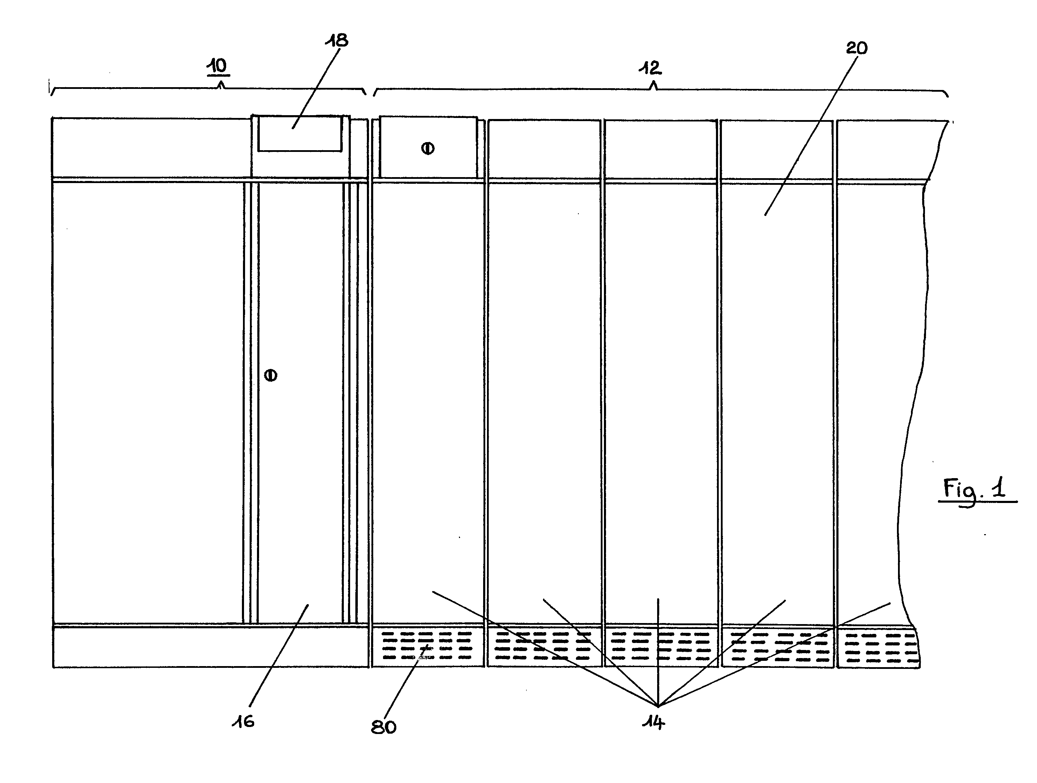

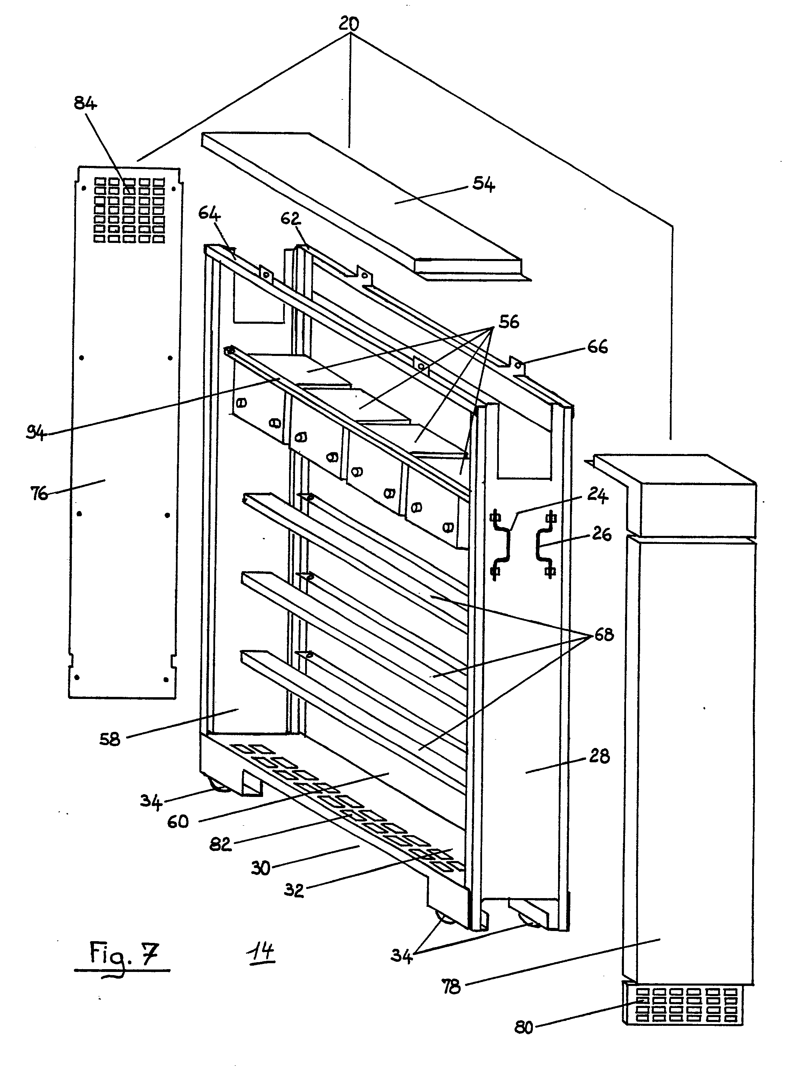

Sur la figure 1, est représenté l'assemblage côte à côte d'une cellule onduleur 10 et d'une source de courant continu formée par une armoire 12 modulaire de plusieurs modules batteries 14. La cellule onduleur 10 du type décrite dans le brevet français 2608353, est équipée d'une porte 16 d'accès à l'intérieur de la cellule, et d'une console 18 de visualisation avec clavier de commande. Chaque module batterie 14 de l'armoire 12 comporte son propre habillage 20 métallique externe (montré en détail à la figure 7), mais il est également possible de rapporter un habillage commun à plusieurs modules 14.

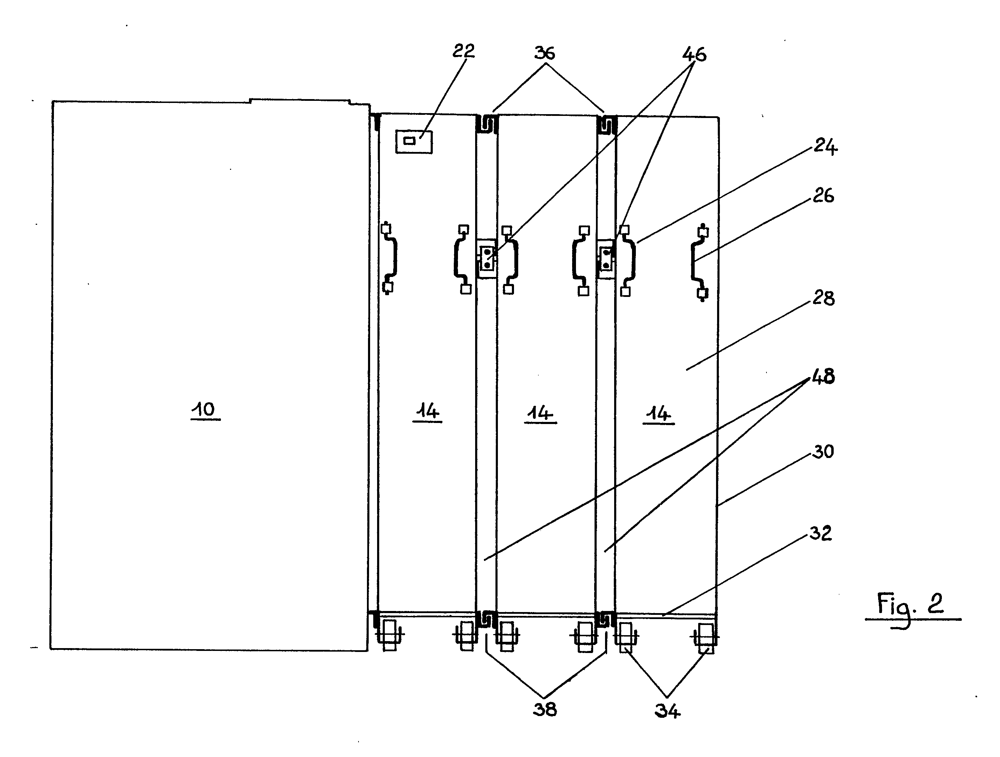

Sur la figure 2, l'armoire modulaire 12 est composée de trois modules batteries 14, dont l'habillage 20 externe a été enlevé. La source de courant continu est raccordée électriquement à l'onduleur par un disjoncteur 22 de couplage, logé dans la partie supérieure du premier module batterie 14 juxtaposé à la cellule onduleur 10. Chaque module 14 est extractible de l'armoire 12 au moyen d'une paire de poignées 24,26 rabattables, situées sur le flasque avant 28 du châssis 30 de forme parallélépipédique. Le socle 32 du châssis 30 est doté de quatre organes de roulement 34 autorisant un mouvement reversible de translation du module 14 dans la direction de la profondeur, c'est à dire selon un plan perpendiculaire à la figure 2. Les organes de roulement 34, par exemple des roulettes ou des rouleaux, sont disposés aux quatre coins du socle 32, et se trouvent en appui direct avec le plancher ou le sol. La manutention de chaque module batterie 14 est ainsi facilitée pour l'utilisateur, grâce à l'absence de toute goulotte ou rail de positionnement dans le sol.

Le déplacement relatif en translation entre deux modules 14 juxtaposés s'opère au moyen d'un premier et d'un deuxième dispositifs de guidage 36,38 horizontal, prévus aux parties supérieures et inférieures des châssis 30 respectifs (figure 2 à 4). Chaque dispositif de guidage 36,38 comporte à titre d'exemple une double glissière 40 latérale formée par l'imbrication de deux profilés 42,44 en U et U renversé fixés sur les parois latérales adjacentes du châssis 30 des modules 14.

Le verrouillage mécanique de deux modules 14 insérés dans l'armoire 12 est assuré par un verrou 46 de retenue (figure 2), situé avec les glissières 40 des deux dispositifs de guidage 36,38 dans un intervalle 48 transversal de séparation de deux modules 14. Le retrait du verrou 46 intervient lors de chaque mise en place ou extraction d'un module 14.

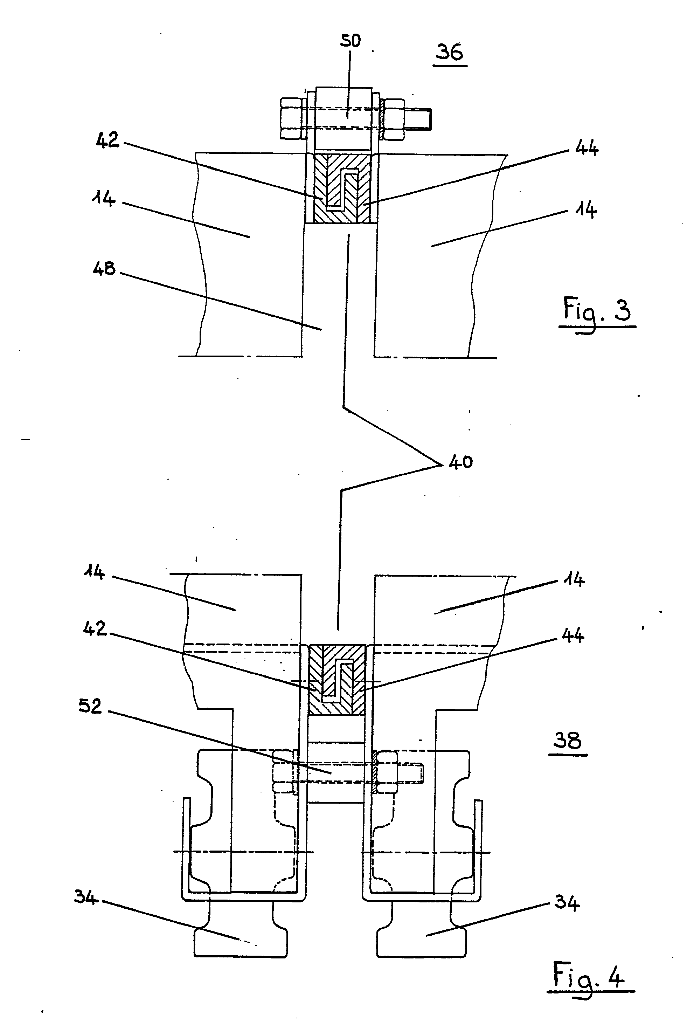

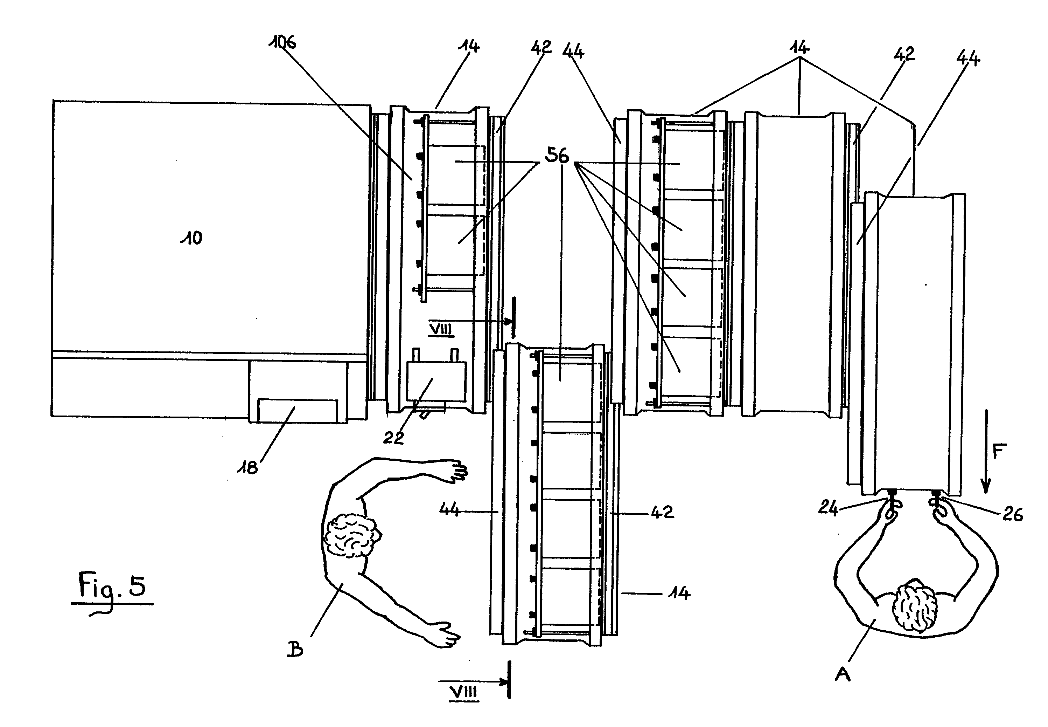

Le transport d'un ensemble monobloc de deux modules 14 nécessite un ancrage mécanique différent, formé par deux jeux de boulons 50 (figure 3) et 52 (figure 4), disposés dans le plan de l'intervalle 48 respectivement au-dessus et en-dessous des glissières 40 des deux dispositifs de guidage 36,38. Le verrou 46 est enlevé durant le transport, et remplacé par les boulons 50,52.

La vue en plan de l'armoire 12 (figure 5) avec cinq modules batteries 14 montre que la cellule onduleur 10 présente la même profondeur que les modules batteries 14 associés. Le toit 54 de l'habillage 20 des trois premiers modules 14 a été enlevé pour voir l'agencement interne des différents accumulateurs 56 de la rangée supérieure. L'utilisateur A représenté à droite est en train d'extraire le cinquième module 14 dans le sens de la flèche "F", en se servant des poignées 24,26 de préhension. Le guidage en translation s'effectue par coopération du premier profilé 42 en U solidaire de la face latérale de droite du quatrième module 14, et du deuxième profilé 44 en U renversé fixé à la face latérale de gauche du cinquième module 14. L'utilisateur B de gauche est en train d'examiner l'ensemble des accumulateurs 56 logés dans le deuxième module 14 en position d'extraction.

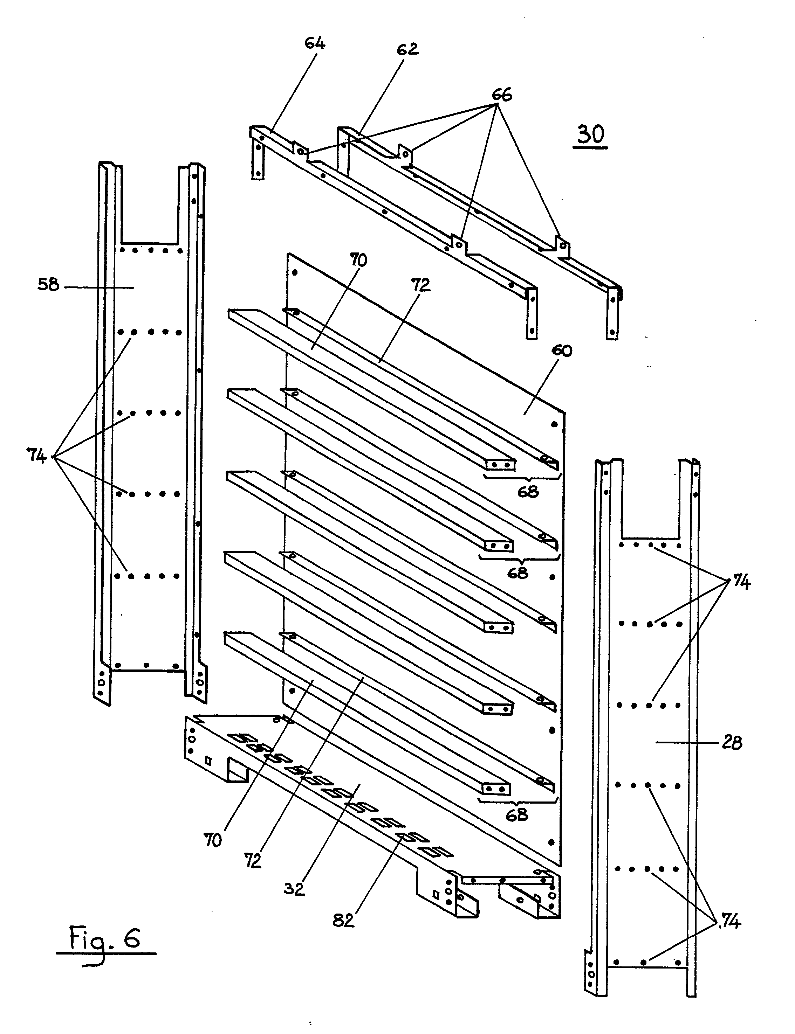

Sur la figure 6, le châssis 30 de chaque module 14 comporte une ossature parallélépipédique en tôle, ayant en plus du flasque avant 28 et du socle 32 rectangulaire, un flasque arrière 58 s'étendant parallèlement au flasque avant 28, et un fond 60 latéral fermé agencé entre les deux flasques 28,58 dans un plan vertical perpendiculaire au socle 32. A l'opposé du socle 32, une paire de barres 62,64 relie les flasques 28,58 selon une direction parallèle au fond 60 pour assurer la rigidité mécanique du châssis 30. Chaque barre 62,64 horizontale est dotée de deux oreilles 66 pour la fixation des profilés 42,44 appartenant au dispositif de guidage supérieur 36. Les autres profilés 42,44 du dispositif de guidage inférieur 38 sont fixés sur les faces latérales opposées du socle 32. L'écartement des deux barres 62,64 correspond à la largeur du socle 32.

Le châssis 30 est équipé d'une pluralité d'étagères 68 parallèles, échelonnées à intervalles réguliers dans le sens de la hauteur. Chaque étagère 68 est formée par la combinaison d'une plaquette support 70 et d'une cornière de maintien 72 disposées dans un même plan horizontal. Les plaquettes supports 70 sont assemblées par rivetage ou vissage sur les flasques avant 28 et arrière 58, tandis que les cornières 72 sont fixées directement au fond 60. La présence d'orifices 74 d'ajustage dans les flasques 28,58 permet un réglage de la position latérale des plaquettes supports 70 pour adapter la surface de chaque étagère 68 aux dimensions des accumulateurs 56.

Sur la figure 7, le châssis 30 terminé d'un module de batterie 14 est montré après assemblage par vissage ou rivetage de l'ensemble fond 60, flasques 28,58, socle 32 et barres supérieures 62,64. Le châssis 30 est alors prêt à recevoir l'habillage 20 métallique externe, après mise en place et répartition préalables des accumulateurs 56 sur les différentes étagères 68 horizontales. L'habillage 20 du châssis 30 comporte le toit 54 destiné à être rapporté sur les barres 62,64 supérieures, une tôle 76 postérieure et une tôle 78 antérieure susceptibles de recouvrir respectivement la surface extérieure des flasques 58,28.

La ventilation de l'intérieur d'un module 14 s'opère à travers différentes grilles 80,82,84 judicieusement positionnées pour assurer un écoulement d'air de refroidissement par effet de cheminée. Une ventilation forcée peut également être envisagée en fonction des critères d'environnement, et de la capacité de la batterie d'accumulateurs. Les grilles d'aspiration 80,82 sont agencées dans la zone inférieure du module 14, respectivement dans la tôle 78 antérieure et dans le socle 32, tandis que la grille d'échappement 84 se trouve dans la zone supérieure du module 14, par exemple dans la tôle postérieure 84 de l'habillage 20 (figure 7).

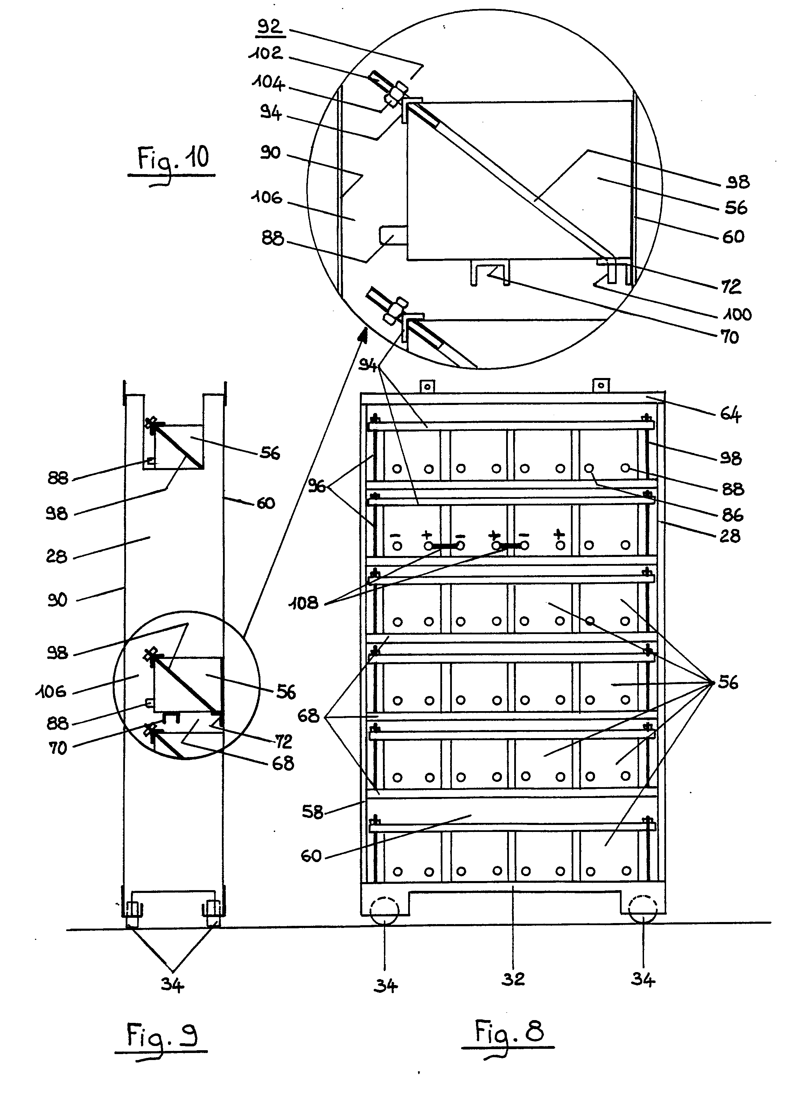

En référence aux figures 8 à 10, les différents accumulateurs 56 sont répartis côte à côte par quatre sur chaque étagère 68 horizontale. Un nombre supérieur ou inférieur d'accumulateurs 56 peut être choisi dans chaque rangée en fonction de l'encombrement et du type. Dans le cas d'accumulateurs 56 étanches sans entretien, la configuration du module 14 permet d'envisager une position couchée latérale, dans laquelle le couvercle portant les deux bornes 86,88 de polarités positive et négative de chaque accumulateur 56 est dirigé vers la face latérale ouverte 90 du châssis 30. A l'opposé des bornes 86,88, la base de l'accumulateur 56 est orientée vers le fond 60 du châssis 30. Dans chaque rangée, les accumulateurs 56 reposent par l'une de leurs parois latérales sur l'étagère 68 correspondante, tels que les différentes bornes 86,88 se trouvent alignées selon une direction parallèle à ladite étagère 68.

Les quatre accumulateurs 56 d'une même rangée sont maintenus en place par un dispositif de verrouillage mécanique 92 comprenant une entretoise 94 de retenue coopérant à ses extrémités opposées avec deux tirants 96,98 de fixation s'étendant selon une direction oblique. L'entretoise 94 horizontale en forme de profilé en équerre, prend appui sur l'arête antérieure et supérieure de chaque accumulateur 56. L'une des extrémités recourbée 100 de chaque tirant 96,98 est enfilée dans un trou de la cornière 72 de l'étagère 68, tandis que l'extrémité opposée 102 est filetée pour la réception d'un écrou 104 de serrage (figure 10). L'extrémité 102 traverse l'entretoise 94, et l'écrou 104 prend appui sur l'entretoise 94.

Un espace 106 transversal est ménagé entre les accumulateurs 56 et la face latérale ouverte 90 sur toute la hauteur du module 14. Cet espace 106 crée un volume vertical libre, qui autorise l'interconnexion en série ou parallèle des différents accumulateurs 56, et améliore la ventilation à l'intérieur du module 14.

En position d'extraction d'un module 14, l'utilisateur B (figure 5) voit à travers la face ouverte 90 l'ensemble des blocs accumulateurs 56, tel que représenté à la figure 8. Il en résulte une accessibilité complète aux bornes 86,88 et aux connexions 106, (voir deuxième rangée), ce qui facilite les opérations de montage, d'insertion et de maintenance. La réalisation du câblage électrique entre les blocs accumulateurs 56 des différentes rangées est effectué de façon modulaire et standard.

Selon une variante, les blocs accumulateurs 56 au lieu d'être couchés, peuvent être montés debout, avec leurs bases respectives en appui sur les étagères 68.

## Revendications

1. Armoire modulaire (12) pour batteries d'accumulateurs électriques, associée notamment à une cellule onduleur (10), et comprenant une pluralité de modules batteries (14) ayant chacun un châssis (30) extractible, équipé d'étagères (68) horizontales superposées dans le sens de la hauteur pour le support des blocs accumulateurs (56), le châssis (30) présentant une ossature métallique de forme parallélépipédique, ayant un socle (32) de section rectangulaire parallèle aux différentes étagères (68), caractérisée en ce que le châssis 30 comporte :
- des organes de roulement (34) fixés à la base du socle (32) pour assurer le déplacement du module (14) dans la direction de la profondeur entre une position d'insertion et une position d'extraction,
- un premier flasque avant (28) vertical s'étendant perpendiculairement au socle (32),
- un deuxième flasque arrière (58) parallèle au premier flasque (28) avec interposition des étagères (68) dans la direction de la profondeur,
- un fond latéral fermé de liaison des deux flasques (28,58) et du socle (32),
- un espace (106) libre transversal ménagé entre les blocs accumulateurs (56) et la face latérale (90) ouverte à l'opposé du fond (60), le déplacement en translation du module (14) vers la position d'extraction autorisant l'accessibilité totale de l'ensemble des blocs accumulateurs à travers ladite face latérale (90) ouverte,
- et des moyens de guidage (36,38) latéraux pour permettre d'une part l'accrochage mécanique en position d'insertion de deux modules (14) ou d'un module à la cellule onduleur (10) et d'autre part le guidage en translation lors du mouvement relatif en translation (14) du module.

2. Armoire modulaire pour batteries d'accumulateurs, selon la revendication 1, caractérisée en ce que les moyens de guidage (36,38) comportent un premier profilé (42) et un deuxième profilé (44) parallèle de forme conjuguée, la coopération du premier profilé (42) de l'un des modules avec le deuxième profilé (44) du module voisin engendrant une glissière (40) disposée dans un intervalle (48) transversal de séparation des deux modules.

3. Armoire modulaire pour batteries d'accumulateurs selon la revendication 1 ou 2, caractérisée en ce que les accumulateurs (56) sont répartis côte à côte sur les étagères (68) selon une position couchée latérale, dans laquelle le couvercle portant les deux bornes (86,88) de chaque accumulateur (56) est dirigé vers la face latérale (90) ouverte du module (14).

4. Armoire modulaire pour batteries d'accumulateurs selon la revendication 1 ou 2, caractérisée en ce que les accumulateurs (56) sont montés debout avec leurs bases en appui sur les étagères (68).

5. Armoire modulaire pour batteries d'accumulateurs selon la revendication 3 ou 4, caractérisée en ce que le module (14) comporte des grilles d'aspiration (80,82) et d'échappement (84) autorisant la ventilation interne à travers le volume vertical de l'espace 106 libre.

6. Armoire modulaire pour batteries d'accumulateurs selon l'une des revendications 1 à 5, caractérisée en ce que le flasque avant (28) du châssis (30) est doté de poignées de préhension (24,26) pour la manutention du module (14), et que les accumulateurs d'une même rangée sont maintenus en place par un dispositif de verrouillage (92) mécanique comprenant une entretoise (94) de retenue coopérant à ses extrémités opposées avec deux tirants (96,98) obliques.

7. Armoire modulaire pour batteries d'accumulateurs selon l'une des revendications 1 à 6, caractérisée en ce que chaque étagère (68) est composée d'une plaquette support (70) solidarisée aux deux flasques avant (28) et arrière (58), et une cornière de maintien (72) fixée au fond (60) dans un même plan horizontal.

8. Armoire modulaire pour batteries d'accumulateurs, selon la revendication 7, caractérisée en ce que chaque flasque avant (28) et arrière (58) est doté au niveau de chaque rangée d'orifices (74) pour l'ajustage de la position latérale de la plaquette support (70) correspondante pour adapter la surface de l'étagère (68) à l'encombrement des accumulateurs (56).

9. Armoire modulaire pour batteries d'accumulateurs selon l'une des revendications 2 à 8, caractérisée en ce que le verrouillage mécanique de deux modules (14) est assuré soit par un verrou (46) de retenue situé dans l'intervalle (48) transversal, soit par un système de boulons (50,52).

Fig. 1

EP 0 362 083 A1

Fig. 2

Fig. 3

Fig. 4

Fig.5

EP 0 362 083 A1

Fig. 6

Fig. 7

Fig. 10

Fig. 9

Fig. 8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN, vol. 10, no. 79 (E-391)[2136], 28 mars 1986; & JP-A-60 225 351 (HITACHI SEISAKUSHO K.K.) 09-11-1985 --- | 1 | H 01 M 2/10 H 05 K 7/18 |
| A | EP-A-0 181 729 (WEHR CORP.) * Figure 1 * --- | 1 | |
| A | US-A-4 325 799 (GORDY et al.) * Figure 1 * --- | 1 | |
| A | US-A-2 173 736 (J.C. THOMAS) * Page 3, colonne de gauche, lignes 37-44; revendications 4,5 * --- | 1 | |
| A | DE-C- 19 161 (COAD) * En entier * ----- | 1 | |

DOMAINES TECHNIQUES RECHERCHES (Int. Cl.5)

H 01 M
H 05 K

Le présent rapport a été établi pour toutes les revendications

| Lieu de la recherche | Date d'achèvement de la recherche | Examinateur |
|---|---|---|
| LA HAYE | 19-12-1989 | CZECH B.P. |